# EUROPEAN PATENT APPLICATION

(11) **EP 1 480 276 A1**
(43) Date of publication of application: **24.11.2004**
(21) Application number: 02711245.7
(22) Date of filing: 31.01.2002
(51) Int. Cl.: H01L 31/042

(54) **SUBSTRATE FOR PHOTOELECTRIC CONVERSION DEVICE**

(71) Applicant: Nippon Sheet Glass Co.,Ltd., Tokyo 105-8552 (JP)
(72) Inventor: KIYOHARA, Koichiro, c/o NIPPON SHEET GLASS CO. LTD, Osaka-shi, Osaka 541-8559 (JP); ICHIKI, Kiyotaka, c/o NIPPON SHEET GLASS CO. LTD., Osaka-shi, Osaka 541-8559 (JP); YAMAMOTO, Toru, c/o NIPPON SHEET GLASS CO. LTD., Osaka-shi, Osaka 541-8559 (JP); HYODO, Masato, c/o NIPPON SHEET GLASS CO. LTD., Osaka-shi, Osaka 541-8559 (JP); HIRATA, Masahiro, c/o NIPPON SHEET GLASS CO. LTD., Osaka-shi, Osaka 541-8559 (JP)
(74) Representative: Paget, Hugh Charles Edward
(86) International application number: PCT/JP2002/000748
(87) International publication number: WO 2003/065461

(57) **Abstract**

The present invention provides a substrate for photoelectric conversion devices including an undercoating film and a conductive film that are formed sequentially on a glass sheet. Chloride fine particles are present in the undercoating film or at the interface between the undercoating film and the conductive film. Convex portions are formed on the surface of the conductive film above the chloride fine particles.

## Description

### TECHNICAL FIELD

The present invention relates to a substrate for photoelectric conversion devices, particularly to a substrate for photoelectric conversion devices that includes a conductive film whose surface has concavities and convexities that are effective for improvement in photoelectric conversion efficiency.

### BACKGROUND ART

Thin film photoelectric conversion devices have been receiving attention due to the low energy cost required for the manufacture thereof. Generally, the thin film photoelectric conversion device includes an undercoating film, a transparent conductive film, a photoelectric conversion unit including a photoelectric conversion layer, and a metal film (a back electrode), which are formed sequentially on the surface of a glass sheet. As the transparent conductive film, a tin oxide film formed by a method accompanied by a pyrolytic oxidation reaction of raw materials, such as a chemical vapor deposition method (a CVD method) for example, is used in many cases. The undercoating film is provided for preventing an alkali component that is contained in the glass sheet from diffusing into the transparent conductive film, thus preventing the increase in resistance of the transparent conductive film. A transparent thin film such as a silicon oxide film is used as the undercoating film.

The transparent conductive film of the thin film photoelectric conversion device is required to have a high transmittance (i.e. to introduce a larger quantity of light into the photoelectric conversion layer) and a low resistance (i.e. to reduce the loss that is caused in leading out the generated electricity). It has been known that proper concavities and convexities provided for the surface of the transparent conductive film are effective in trapping light in the photoelectric conversion layer. When the transparent conductive film is a tin oxide film, for example, its surface shape is affected by the size and shape of tin oxide crystals. Hence, conventionally, for example, the tin oxide film is formed to have a crystal plane with a predetermined orientation and thereby the surface shape is optimized. However, there is a limitation in controlling the surface shape through the adjustment of conditions for forming the tin oxide film.

Generally, the undercoating film is formed as a film with a smooth surface. On the contrary, JP62(1987)-44573A discloses a silicon dioxide film with a surface provided with concavities and convexities through the introduction of silicon dioxide particles thereto. The silicon dioxide particles are generated by a partial reaction between monosilane and oxygen. Since monosilane has an excessively high reactivity, nitrogen is introduced as a separation gas, which is intended to prevent the monosilane from being oxidized in the above-mentioned reference. As described in the above-mentioned reference, however, even if monosilane is supplied while being separated from oxygen using nitrogen, monosilane reacts with oxygen rapidly in the reaction space. Consequently, the silicon dioxide particles have large diameters, specifically, 100 nm to 400 nm. It has been reported that the silicon dioxide film formed of these particles had convex portions whose radii and heights were as large as about 500 nm and as high as about 300 nm, respectively.

### DISCLOSURE OF THE INVENTION

With the above-mentioned situation in mind, the present invention is intended to provide a new substrate for photoelectric conversion devices that has a surface provided with concavities and convexities having an effect in improving the light trapping effect in a photoelectric conversion layer.

In order to achieve the above-mentioned object, a first substrate for photoelectric conversion devices of the present invention includes an undercoating film and a conductive film that are formed sequentially on a glass sheet. The first substrate is characterized in that chloride fine particles are present in the undercoating film or at an interface between the undercoating film and the conductive film, and convex portions are formed on the surface of the conductive film above the chloride fine particles.

Furthermore, a second substrate for photoelectric conversion devices of the present invention includes an undercoating film and a conductive film that are formed sequentially on a glass sheet. The second substrate is characterized in that dome-shaped convex portions with diameters of at least 100 nm are formed on the surface of the conductive film.

In the first substrate for photoelectric conversion devices of the present invention, besides the convex portions formed due to the presence of the chloride fine particles, dome-shaped convex portions with diameters of at least 100 nm may be formed on the surface of the conductive film as in the second substrate for photoelectric conversion devices.

### BRIEF DESCRIPTION OF DRAWINGS

FIG. 1 is a cross-sectional view showing one embodiment of the substrates for photoelectric conversion devices according to the present invention.
FIG. 2 is a cross-sectional view showing one embodiment of the substrates for photoelectric conversion devices according to the present invention.
FIG. 3 is a diagram showing the configuration of an example of the apparatus that is used for manufacturing the substrates of the present invention.
FIG. 4 is a cross-sectional view showing an example of the coater that is used for manufacturing the substrates of the present invention.
FIG. 5 is a photograph showing the state of an undercoating film produced according to an example that was observed with a scanning electron microscope.
FIG. 6 is a photograph showing the state of a substrate for photoelectric conversion devices manufactured according to another example that was observed with a scanning electron microscope.

### BEST MODE FOR CARRYING OUT THE INVENTION

Hereinafter, preferred embodiments of the present invention will be described with reference to the drawings.

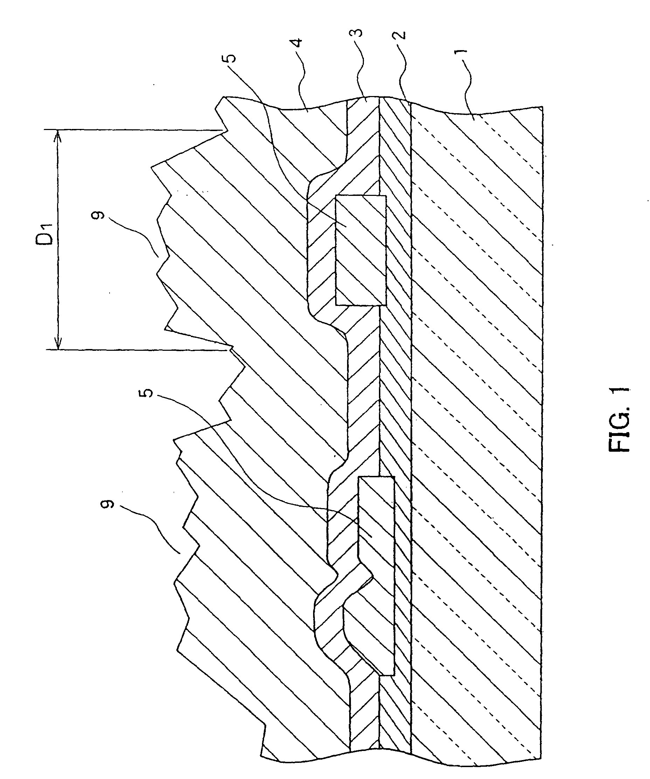

FIG. 1 is a cross-sectional view showing one type of the first substrate for photoelectric conversion devices according to the present invention. In this substrate for photoelectric conversion devices, undercoating films (a first undercoating film 2 and a second undercoating film 3) and a transparent conductive film 4 are stacked sequentially on a glass sheet 1.

Chloride fine particles 5 are present at the interface between the first undercoating film 2 and the second undercoating film 3. The chloride fine particles are, for instance, fine particles of alkali metal chloride such as sodium chloride. In this case, they often take shapes reflecting the rock-salt crystal structure as shown in FIG. 1. The surface of the transparent conductive film 4 is provided with convex portions 9 formed with the surface locally rising above the fine particles. These convex portions 9 are larger in diameter and higher than the concavities and convexities that are formed along the exposed surfaces of the crystal grains.

A suitable diameter *D*_{*1*} of the convex portions 9 is at least 100 nm, particularly about 100 nm to 500 nm. Preferably, the distribution density of the fine particles (that is, the distribution density of the convex portions) is at least 100 pieces per 100 µm², particularly about 100 to 1000 pieces per 100 µm². When the size and distribution density of the convex portions are in the above-mentioned ranges, a desirable light trapping effect can be obtained.

Chloride fine particles that have been prepared separately may be supplied by dispersing. However, when they are allowed to be generated during the formation of the first undercoating film, a film having concavities and convexities formed due to the presence of the fine particles can be manufactured efficiently. Specifically, it is convenient that in forming the first undercoating film, using the CVD method employing a coating-film forming gas including chlorine-containing compounds, the chlorine of the chlorine-containing compounds is allowed to react with alkali components (mainly sodium and potassium) that are contained in glass and thereby chloride fine particles are generated. Thus, when the chloride fine particles are allowed to be present in the film that is formed at the same time the chloride fine particles are formed, without being exhausted through an exhausting system, the undercoating film with fine particles present therein as shown in the drawing can be formed efficiently.

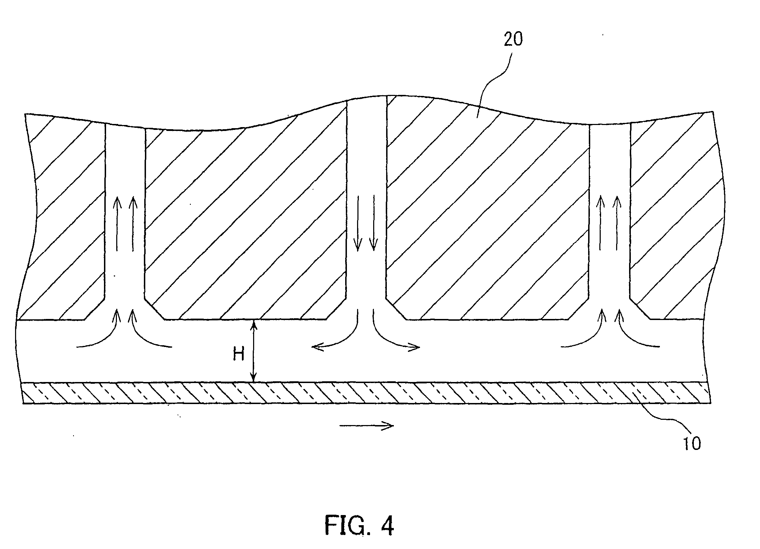

In order to allow the alkali components and the chlorine-containing compounds to react with each other, it is preferable that the glass temperature is maintained at 600°C or higher, for instance, 600°C to 720°C. The "glass temperature" is specifically the temperature of the glass sheet or that of a glass ribbon that is formed in a process of manufacturing the glass sheet. Generally, in the CVD method, the ratio of an amount of gas to be exhausted to an amount of gas to be supplied (hereinafter referred to as an "exhaust bias") is adjusted to be high to a degree that prevents impurities from being introduced into the film. In order to allow fine particles to be present in the film, however, it is convenient to adjust the exhaust bias to be lower than that in the conventional common range. The height from the glass surface to the lower end of a coater that supplies and exhausts gas (hereinafter referred to as "height of coater") also affects the behavior of the fine particles considerably. Accordingly, the introduction of the fine particles into the film can be carried out mainly through the adjustments to the exhaust bias and the height of coater. In this connection, the height of coater corresponds to the distance Hbetween a substrate (in this case, a glass ribbon 10 formed in the glass sheet manufacturing process) and a coater 20 as shown in FIG. 4.

In the type shown in the drawing, the chloride fine particles 5 are present inside the undercoating films 1 and 2. The fine particles, however, may be present in a state of protruding from the undercoating films. For instance, when the formation of the second undercoating film 2 is omitted, the chloride fine particles 5 are present at the interface between the first undercoating film 1 and the transparent conductive film 4. The number of layers of the undercoating film and transparent conductive film is not limited to that in the type shown in the drawing.

Preferably, the first undercoating film 1 contains, as its main component, tin oxide, titanium oxide, indium oxide, or zinc oxide, and may contain minor components such as fluorine, chlorine, or the like. Furthermore, it may contain other metallic elements as minor components and may be, for example, a film made of tin oxide containing silicon.

The second undercoating film 2 preferably contains, as its main component, silicon oxide or aluminum oxide. Particularly, it is preferable that the second undercoating film is a silicon oxide film.

Other preferable examples of the undercoating films include films containing, as their main component, oxycarbides or oxynitrides of the metals described above such as, for instance, SiOC.

The conductive film 3 preferably contains, as its main component, tin oxide, indium oxide doped with tin, or zinc oxide. A tin oxide film that is doped with, for instance, fluorine or antimony so as to have improved conductivity is particularly suitable for the conductive film. The amounts of elements to be added are not particularly limited. A suitable amount of fluorine, however, is 0.05 wt.% to 1 wt.%.

Preferable thicknesses of the respective films described above are indicated below as examples.

| | |
|---|---|
| First Undercoating Film | 10 nm to 100 nm |
| Second Undercoating Film | 10 nm to 100 nm |
| Transparent Conductive Film | 500 nm to 1200 nm |

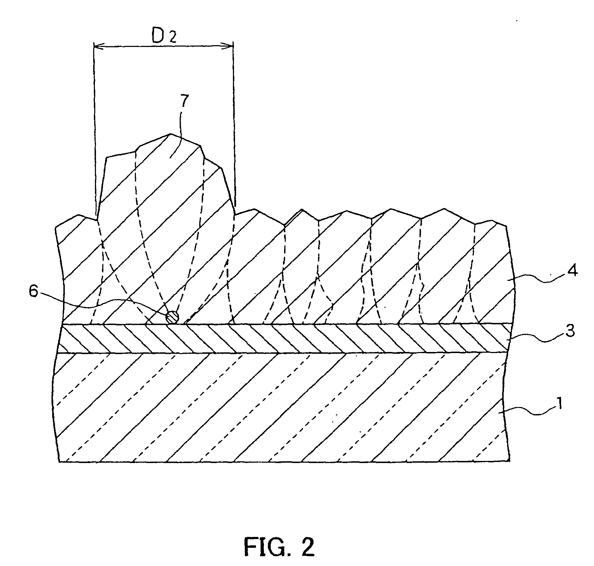

FIG. 2 is a cross-sectional view showing one type of the second substrate for photoelectric conversion devices according to the present invention. In this substrate for photoelectric conversion devices, an undercoating film 3 and a transparent conductive film 4 are stacked sequentially on a glass sheet 1.

The surface of the undercoating film (i.e. the interface between the undercoating film 3 and the transparent conductive film 4) reflects high smoothness of the glass sheet surface and thus is substantially flat. On the other hand, the transparent conductive film 4 has a dome-shaped convex portion 7 on its surface. As shown with broken lines in FIG. 2, a crystal grain that has grown locally abnormally exists inside the dome-shaped convex portion. This convex portion 7 is higher and larger in diameter than the concavities and convexity that are formed along the exposed surface of the crystal grain.

A suitable diameter *D*_{*2*} of the convex portion 7 is at least 100 nm, particularly about 100 nm to 500 nm. Furthermore, a preferable distribution density of convex portions (that is, the distribution density of fine particles) is at least 10 pieces per 100 µm², particularly about 10 to 1000 pieces per 100 µm². When the size and distribution density of the convex portions are in the ranges mentioned above, a desirable light trapping effect can be obtained.

The local growth of the crystal grain can be promoted by, for instance, forming a crystalline transparent conductive film 4, with a crystal growth nucleus 6 being present on the surface of the undercoating film 3. A minute particle whose diameter is not larger than about 100 nm, more specifically about 5 nm to 40 nm is suitable as the crystal growth nucleus 6. Even if such a minute growth nucleus exists, the flatness of the interface between the undercoating film and the transparent conductive film is not impaired significantly. In the present specification, the surface of the undercoating film is considered to be substantially flat as long as it has no concavities nor convexities whose height exceeds 100 nm.

In this case, it also may be possible to disperse fine particles that have been prepared separately. However, when the formation of the undercoating film is accompanied by generation of fine particles, a film having the growth nucleus 6 on its surface can be manufactured efficiently. For instance, when a silicon oxide film that is suitable as the undercoating film is to be formed, fine particles containing silicon may be generated, in forming the silicon oxide film, using the CVD method that employs a coating-film forming gas including a silicon-containing compound. Then, the fine particles are allowed to adhere to the surface of the silicon oxide film, at least part of which is formed simultaneously with the formation of the fine particles, without being exhausted through the exhausting system. Accordingly, an undercoating film can be formed that is provided with fine particles exposed thereon as shown in the drawing.

When the coating-film forming gas has excessively high reactivity, it tends to be difficult to generate fine particles having small diameters that are suitable as the crystal growth nuclei. Hence, when using, for example, monosilane as the silicon-containing compound, it is advantageous to add an organic gas having a carbon-carbon unsaturated bond, such as ethylene or acetylene, to ease the very high reactivity of monosilane. Furthermore, a silicon-containing organic compound such as tetraethyl orthosilicate (TEOS) may be used instead of monosilane.

In the embodiment shown in the drawing, a single layer of undercoating film is included. However, a plurality of layers of at least two undercoating films may be formed as in the type shown in FIG. 1. In this case, it is advantageous that when the layer that comes into contact with the conductive film is formed, crystal growth nuclei are generated to adhere to the film surface. Suitable materials for the undercoating film and transparent conductive film are as described above.

When a single layer of undercoating film is formed, it is advantageous that the material suitable for the second undercoating film is used for it. In this connection, the preferable thickness of the single layer of undercoating film is 10 nm to 100 nm.

A preferable embodiment of the method of manufacturing the above-mentioned substrate for photoelectric conversion devices can be a method of stacking the above-mentioned respective films sequentially on the top surface of a glass ribbon in a float glass manufacturing process using the heat of the glass ribbon. The film formation method using heat of the glass ribbon can be a spraying method in which a material liquid is atomized to be supplied onto the glass ribbon surface or the CVD method in which a raw material is vaporized to be supplied onto the glass ribbon surface.

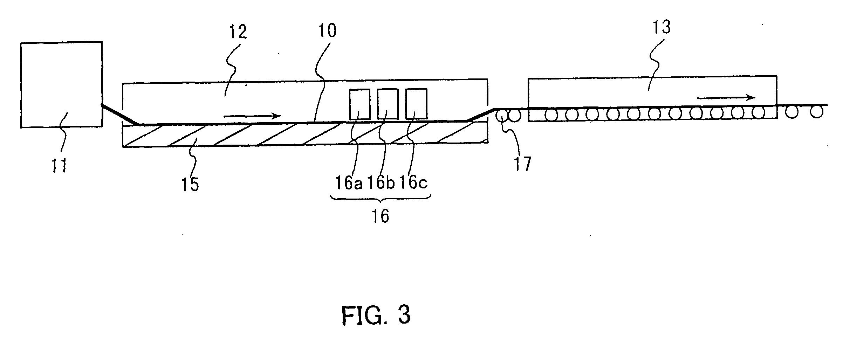

FIG. 3 shows one type of the apparatus for forming a thin film on the glass ribbon surface by the CVD method in the float glass process. As shown in FIG. 3, in this apparatus, a predetermined number of coaters 16 (three coaters 16a, 16b, and 16c in the type shown in the drawing) are disposed directly above a glass ribbon 10. The glass ribbon 10 is formed from molten glass, which is poured from a melting furnace 11 into a float bath 12 to be formed into a belt-like form on a tin bath 15 while moving thereon. The number and arrangement of the coaters may be selected suitably depending on the type and thickness of the coating film to be formed. These coaters supply materials, which have been prepared and evaporated, to form coating films on the glass ribbon 10 surface (top surface) successively. By supplying different materials from the respective coaters, the first undercoating film, the second undercoating film, and the transparent conductive film can be stacked successively. The temperature of the glass ribbon 10 is controlled by a heater and a cooler (not shown in the drawing) installed inside the float bath 12 so that the glass ribbon 10 has a predetermined temperature directly before reaching the coaters 16.

In this case, it is preferable that the predetermined temperature of the glass ribbon is in the range of 600°C to 750°C, particularly 630°C to 750°C. The temperature of the glass ribbon 10 may be measured with a radiation thermometer to be controlled. The glass ribbon 10 with the coating films thus formed is lifted by a roller 17 and then is annealed in an annealing furnace 13.

Examples of tin materials that can be used in forming a thin film containing tin oxide as its main component by the CVD method include monobutyltin trichloride, tin tetrachloride, dimethyltin dichloride, dibutyltin dichloride, dioctyltin dichloride, and tetramethyltin. Organic tin chlorides such as, for instance, monobutyltin trichloride and dimethyltin dichloride that contain chlorine in a tin compound are particularly suitable when a tin oxide film including chloride fine particles is to be formed. Examples of the oxidation material can include oxygen, water vapor, and dry air. When fluorine is to be added to the conductive film, examples of the fluorine material include hydrogen fluoride, trifluoroacetic acid, bromotrifluoromethane, and chlorodifluoromethane.

When being formed as the undercoating film including chloride fine particles, a film containing, for instance, titanium oxide, indium oxide, or zinc oxide as its main component may be formed using a chloride-containing material such as metal chloride (for instance, titanium tetrachloride or zinc dichloride) by the CVD method as in the above.

Examples of the silicon material to be used in forming a thin film containing silicon oxide as its main component by the CVD method include monosilane, disilane, trisilane, monochlorosilane, 1,2-dimethylsilane, 1,1,2-trimethyldisilane, 1,1,2,2-tetramethyl disilane, tetramethyl orthosilicate, and tetraethyl orthosilicate. The oxidation material to be used in this case can be, for example, oxygen, water vapor, dry air, carbon dioxide, carbon monoxide, nitrogen dioxide, or ozone. Furthermore, as described above, when a raw material having an extremely high reactivity such as monosilane is to be used, it is preferable that an unsaturated hydrocarbon gas such as ethylene, acetylene, or toluene is added to control the reactivity.

When a film containing aluminum oxide as its main component is to be formed by the CVD method, the aluminum material to be used can be, for instance, trimethylaluminum, aluminum triisopropoxide, diethylaluminum chloride, aluminum acetylacetonate, or aluminum chloride. In this case, for example, oxygen, water vapor, or dry air can be used as the oxidation material.

### Examples

Hereinafter, the present invention is described further in detail using examples but is not limited to the following examples.

### Substrate for Photoelectric Conversion Devices including Chloride Fine Particles

In Examples 1 and 2 as well as Comparative Examples 1 and 2, thin films were stacked on a glass ribbon surface by the CVD method using the same apparatus as that described with reference to FIGs. 3 and 4. During the film formation, a mixed gas consisting of 98 vol.% of nitrogen and 2 vol.% of hydrogen was supplied into the float bath and thereby the space inside the float bath was maintained at a slightly higher pressure than that outside the bath. A soda-lime glass material that had been melted in a melting furnace was poured into the float bath and was formed into a glass ribbon with a thickness of 4 mm. Specific film formation methods are described below.

### Example 1

A film forming gas consisting of dimethyltin dichloride (DMT), oxygen, and nitrogen was supplied from a coater located on the furthest upstream side at a rate of 500 L/min, with the glass ribbon having a surface temperature of 680°C directly before reaching the coater. With respect to this coater, the exhaust bias was set at 1.2 while the height of coater was set at 8 mm. Thus, a tin oxide film with a thickness of about 23 nm was formed on the top surface of the glass ribbon.

Subsequently, a mixed gas consisting of monosilane, ethylene, and oxygen was supplied from a coater located downstream. The exhaust bias and the height of this coater were set in the ranges that had been used conventionally and were controlled so that even if fine particles of silicon oxide were generated, the film was prevented from including them. Then, a mixed gas consisting of dimethyltin dichloride, oxygen, water vapor, nitrogen, and hydrogen fluoride was supplied from a coater located further downstream. Thus, a silicon oxide film with a thickness of about 25 nm and a SnO₂:F film with a thickness of about 320 nm were stacked sequentially on the tin oxide film. Furthermore, this glass ribbon was cut on a further downstream side and thereby a substrate for photoelectric conversion devices was obtained.

### Comparative Example 1a

A substrate for photoelectric conversion devices was obtained in the same manner as in Example 1 except that the glass temperature was set at 580°C when the tin oxide film was formed on the surface of the glass ribbon.

### Comparative Example 1b

A substrate for photoelectric conversion devices was obtained in the same manner as in Example 1 except that the exhaust bias was set at 2.0 when the tin oxide film was formed on the surface of the glass ribbon.

### Example 2

A substrate for photoelectric conversion devices was obtained in the same manner as in Example 1 except that the thickness of the SnO₂:F film was set at about 600 nm.

### Comparative Example 2

A substrate for photoelectric conversion devices was obtained in the same manner as in Example 2 except that the exhaust bias was set at 2.0 when the tin oxide film was formed on the surface of the glass ribbon.

Haze ratios of the substrates for photoelectric conversion devices obtained in the above were measured. In this case, the haze ratios were measured according to the haze value measurement method described in Japanese Industrial Standards (JIS) K7105-1981. The results are shown in Table 1.

**Table 1**

| | (%) |
|---|---|
| | Haze Ratio |
| Example 1 | 1.2 |
| Comparative Example 1a | 0.7 |
| Comparative Example 1b | 0.7 |
| Example 2 | 8.8 |
| Comparative Example 2 | 5.2 |

The haze ratio can be used as an index of the light trapping effect. The increase in thickness of the tin oxide film that is a crystalline coating film causes the increase in size of crystal grains and thus increases the haze ratio. As shown in Table 1, however, there were considerable differences in haze ratio between the examples and the comparative examples even when the tin oxide films formed in the examples and the comparative examples had the same thickness. The surfaces of the thin films (SnO₂:F films) were observed with the SEM. As a result, it was found that large convex portions were scattered on the film surface in Examples 1 and 2 while being not observed in the comparative examples.

The glass sheets each were broken so that a portion thereof included the convex portions and the cross-section of the portion was observed with the SEM. As a result, it was confirmed that crystal grains were included in the film and were located below the convex portions. The crystal grains were analyzed and thereby it was confirmed that they consisted substantially of sodium chloride. In both Examples 1 and 2, the convex portions had diameters of about 100 nm to 500 nm and heights of about 50 nm to 200 nm. The convex portions had a distribution density of about 100 pieces per 100 µm².

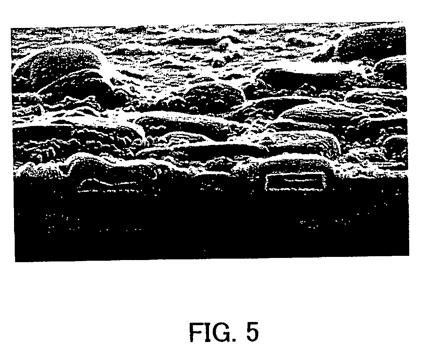

With respect to a glass sheet (with the SnO₂:F film having not been formed thereon yet) with a tin oxide film and a silicon oxide film being formed in the same manner as in Example 1, the states of its cross-section and surface were observed with the SEM. The SEM picture is shown in FIG. 5. When being shown schematically, this cross-section has a configuration like the one shown in FIG. 1.

Conceivably, in Comparative Example 1b, the glass temperature was too low to generate chloride fine particles from the chlorine-containing compound used therein, while in Comparative Examples 1b and 2, the chloride fine particles were exhausted out of the system swiftly.

### Formation of Concavities and Convexities using Silicon-containing Fine Particles

In Example 3 and Comparative Example 3, films similarly were formed on a glass ribbon in the same manner as in the above. In Example 4 and Comparative Example 4, films were formed on a glass sheet. Specific film formation methods are described below.

### Example 3

A film forming gas consisting of dimethyltin dichloride (DMT), oxygen, and nitrogen was supplied from a coater located on the furthest upstream side, with the glass ribbon having a surface temperature of 650°C directly before reaching the coater. Thus, a tin oxide film with a thickness of about 23 nm was formed on the top surface of the glass ribbon. The exhaust bias and the height of coater were set in the ranges that had been used conventionally and were controlled to prevent chloride fine particles generated thereby from being included in the film.

Subsequently, a film forming gas consisting of monosilane, ethylene, and oxygen was supplied from a coater located downstream. With respect to this coater, the exhaust bias was set at 1.2 while the height of coater was set at 12 mm. The mole ratio of ethylene to monosilane of the film forming gas was set at 6. Thus, a silicon oxide film with a thickness of about 25 nm was formed on the tin oxide film.

Then, a mixed gas was supplied from a coater located further downstream to form a SnO₂:F film with a thickness of about 600 nm in the same manner as in Example 1. This glass ribbon was cut on a further downstream side and thereby a substrate for photoelectric conversion devices was obtained.

### Comparative Example 3

A substrate for photoelectric conversion devices was obtained in the same manner as in Example 3 except that the exhaust bias was set at 2.4 and the height of coater was set at 6 mm when the silicon oxide film was formed.

### Example 4

A 3-mm thick glass sheet that had been precut to have a size of 150 mm × 150 mm was placed in an belt furnace and was conveyed below a coater while a film forming gas consisting of monosilane, ethylene, and oxygen was supplied from the coater. The coater used herein had the same configuration as that shown in FIG. 4. The exhaust bias and the height of coater were 1.5 and 25 mm, respectively. The mole ratio of ethylene to monosilane of the film forming gas was set at 6. Thus, a silicon oxide film with a thickness of about 30 nm was formed on the surface of the glass sheet.

Subsequently, while the glass sheet was conveyed below another coater installed in the belt furnace, a mixed gas consisting of dimethyltin dichloride, oxygen, water vapor, nitrogen, and hydrogen fluoride was supplied from the coater onto the tin oxide film. Thus, a substrate for photoelectric conversion devices was obtained with a SnO₂:F film whose thickness was about 600 nm being formed on the silicon oxide film. The temperature of the glass sheet was set at about 600°C in forming both the films described above.

### Comparative Example 4

A substrate for photoelectric conversion devices was obtained in the same manner as in Example 4 except that the exhaust bias was set at 3.1 and the height of coater was set at 13 mm when the silicon oxide film was formed.

The haze ratios of the respective substrates for photoelectric conversion devices thus obtained were determined in the same manner as in the above. The results are shown in Table 2.

**Table 2**

| | (%) |
|---|---|
| | Haze Ratio |
| Example 3 | 8.1 |
| Comparative Example 3 | 4.4 |
| Example 4 | 8.6 |
| Comparative Example 4 | 2.0 |

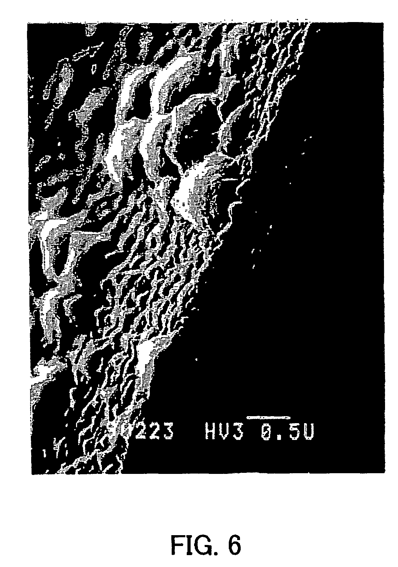

As indicated in Table 2, there were considerable differences in haze ratio between the examples and the comparative examples. The surfaces of the thin films (tin oxide films doped with fluorine) were observed with the SEM. As a result, it was found that large dome-shaped convex portions were scattered on the film surfaces in Examples 3 and 4 while being not observed in the comparative examples. The SEM picture of the surface of the thin film formed according to Example 4 was shown in FIG. 6. The glass sheet was broken so that a portion thereof included the convex portions and then the cross-section of the portion was observed with a transmission electron microscope (TEM). As indicated schematically with the broken lines in FIG. 2, it was confirmed that crystal grains of tin oxide located below the convex portions had grown to partly have an abnormally large size.

Furthermore, a glass sheet having a silicon oxide film alone was produced in the same manner as in Example 4. The surface of this film was observed with the SEM. It was confirmed that fine particles with diameters of about 5 nm to 40 nm were scattered. As the result of analysis, the fine particles were silicon oxide fine particles. On the other hand, such fine particles were not present on the surface of a silicon oxide film formed in the same manner as in Comparative Example 4. In Comparative Example 4 as well as Comparative Example 3, conceivably, the fine particles generated therein were exhausted out of the system swiftly.

The present invention can provide a substrate for photoelectric conversion devices in which concavities and convexities that can contribute to the light trapping effect of the photoelectric conversion layer are formed. It also is possible to allow the concavities and convexities to be remarkably larger than those obtained through the control of crystal grains.

## Claims

1. A substrate for photoelectric conversion devices, comprising an undercoating film and a conductive film that are formed sequentially on a glass sheet,
wherein chloride fine particles are present in the undercoating film or at an interface between the undercoating film and the conductive film, and convex portions are formed on a surface of the conductive film above the chloride fine particles.

2. The substrate for photoelectric conversion devices according to claim 1, wherein the convex portions formed above the chloride fine particles have a distribution density of at least 100 pieces per 100 µm².

3. The substrate for photoelectric conversion devices according to claim 1, wherein the convex portions formed above the chloride fine particles have diameters of 100 nm to 500 nm.

4. The substrate for photoelectric conversion devices according to claim 1, wherein besides the convex portions formed due to the presence of the chloride fine particles, dome-shaped convex portions with diameters of at least 100 nm are formed on the surface of the conductive film.

5. A substrate for photoelectric conversion devices, comprising an undercoating film and a conductive film that are formed sequentially on a glass sheet,
wherein dome-shaped convex portions with diameters of at least 100 nm are formed on a surface of the conductive film.

6. The substrate for photoelectric conversion devices according to claim 5, wherein an interface between the undercoating film and the conductive film is substantially flat.

7. The substrate for photoelectric conversion devices according to claim 5, wherein the dome-shaped convex portions have a distribution density of at least 10 pieces per 100 µm².

8. The substrate for photoelectric conversion devices according to claim 5, wherein the dome-shaped convex portions have diameters of 100 nm to 500 nm.

9. The substrate for photoelectric conversion devices according to claim 1 or 5, wherein the glass sheet is a float glass obtained by a float glass process, and the undercoating film and the conductive film are formed sequentially on a top surface of the float glass.
